Europäisches Patentamt

European Patent Office

Office européen des brevets

(19)

(11) EP 0 654 899 B1

(12)

# FASCICULE DE BREVET EUROPEEN

(45) Date de publication et mention
de la délivrance du brevet:
**13.01.1999  Bulletin 1999/02**

(51) Int Cl.⁶: **H03G 3/20**

(21) Numéro de dépôt: **94402577.4**

(22) Date de dépôt: **15.11.1994**

(54) **Procédé et dispositif de régulation du gain d'un amplificateur de signaux haute fréquence**

Verfahren und Vorrichtung zur Verstärkungsregelung eines Verstärkers für Hochfrequenzsignale

Method and device of gain control of a high frequency amplifier

(84) Etats contractants désignés:
**DE FR GB**

(30) Priorité: **19.11.1993  FR 9313880**

(43) Date de publication de la demande:
**24.05.1995  Bulletin 1995/21**

(73) Titulaire: **THOMSON-CSF**
**75008 Paris (FR)**

(72) Inventeurs:
• **Couthouis, Daniel**
**F-92402 Courbevoie Cedex (FR)**
• **Alalinarde, Pascal**
**F-92402 Courbevoie Cedex (FR)**

(74) Mandataire: **Lincot, Georges et al**
**Thomson-CSF Propriété Intellectuelle,**
**13, Avenue du Président Salvador Allende**
**94117 Arcueil Cédex (FR)**

(56) Documents cités:
**DE-A- 2 710 752**          **US-A- 5 101 173**

## Description

La présente invention concerne un procédé et un dispositif de régulation du gain d'un amplificateur de signaux haute fréquence.

Elle s'applique notamment à la réalisation d'émetteurs récepteurs radiofréquence.

Un dispositif de régulation du gain d'un amplificateur de signaux HF est décrit dans US-A-5 101 173.

Le problème général qui est posé par l'utilisation d'amplificateurs de puissance fonctionnant dans la gamme des ondes hautes fréquences est d'adapter aux conditions d'exploitation la puissance $P_s$ du signal appliqué sur la charge de l'amplificateur à la puissance $P_e$ du signal qui est appliqué à son entrée, le rapport entre ces deux puissances définissant le gain G de l'amplificateur. Cependant pour modifier le gain G en fonction des servitudes d'exploitation qui peuvent agir à la fois sur les caractéristiques électriques de la charge et également de la source d'excitation, les divers dispositifs de régulation du gain G connus ne permettent pas d'optimiser en temps réel la puissance fournie par l'amplificateur lorsque, en fonction des servitudes d'exploitation, la forme d'onde du signal à amplifier varie, le taux d'onde stationnaire à la sortie de l'amplificateur est modifié, la température ambiante évolue ou encore lorsque l'amplificateur est excité en parallèle avec d'autres amplificateurs par une même source d'excitation.

Le but de l'invention est de pallier les inconvénients précités.

A cet effet, l'invention a pour objet un procédé de régulation du gain d'un amplificateur de signaux haute fréquence caractérisé en ce qu'il consiste :

- à déterminer automatiquement une valeur de gain de consigne en fonction des conditions d'exploitation de l'amplificateur
- à mesurer l'écart existant entre l'amplitude du signal appliqué à l'entrée de l'amplificateur et celle d'un signal obtenu en divisant l'amplitude du signal fourni à la sortie de l'amplificateur par la valeur de gain de consigne
- et à minimiser l'écart existant, en pondérant l'amplitude du signal appliqué à l'entrée de l'amplificateur dans le sens qui permet de réduire l'écart.

Elle a également pour objet un dispositif pour la mise en oeuvre du procédé.

D'autres caractéristiques et avantages de l'invention apparaîtront dans la description qui suit faite en regard des dessins annexés qui représentent :

- La figure 1 un dispositif amplificateur haute fréquence mettant en oeuvre le procédé de régulation selon l'invention plus particulièrement adapté au réglage du gain en fonction du taux d'onde stationnaire présent sur sa sortie.
- La figure 2 une variante de réalisation du dispositif de la figure 1.

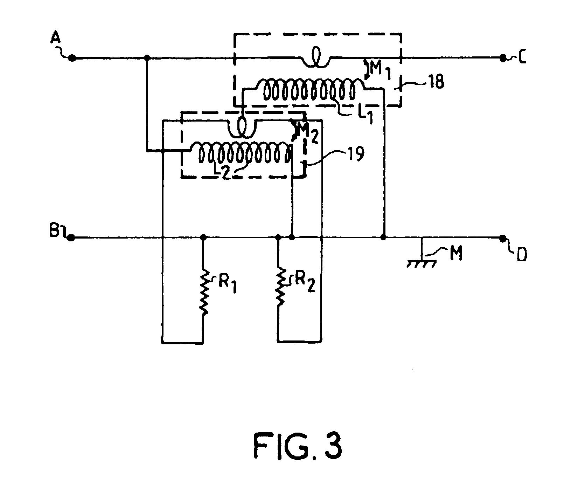

- La figure 3 un mode de réalisation du coupleur de sortie du dispositif amplificateur de la figure 1.

Le procédé selon l'invention consiste à définir une valeur de gain de consigne qui tient compte des conditions d'exploitation de l'amplificateur et de l'amplitude en tension du signal d'entrée pour commander un atténuateur en fonction de l'écart existant entre l'amplitude en tension du signal d'entrée et l'amplitude en tension du signal amplifié divisé par la valeur du gain de consigne, de manière à déterminer une valeur d'atténuation pour laquelle l'écart reste compris entre deux valeurs de seuil prédéterminées.

En désignant par, $V_i(t)$ la tension de sortie du dispositif d'amplification, $V_e(t)$ la tension appliquée à son entrée et par $g_o$ la valeur du gain de consigne, l'écart $\varepsilon$ est calculé en effectuant l'opération

$$\frac{V_i}{g_o} - V_e = \varepsilon \qquad (1)$$

Pour une tension d'entrée et une valeur du gain de consigne déterminées, la réduction de l'écart $\varepsilon$ est obtenue en agissant sur la tension $V_i$ délivrée à la sortie du dispositif d'amplification par le biais d'un atténuateur réglable.

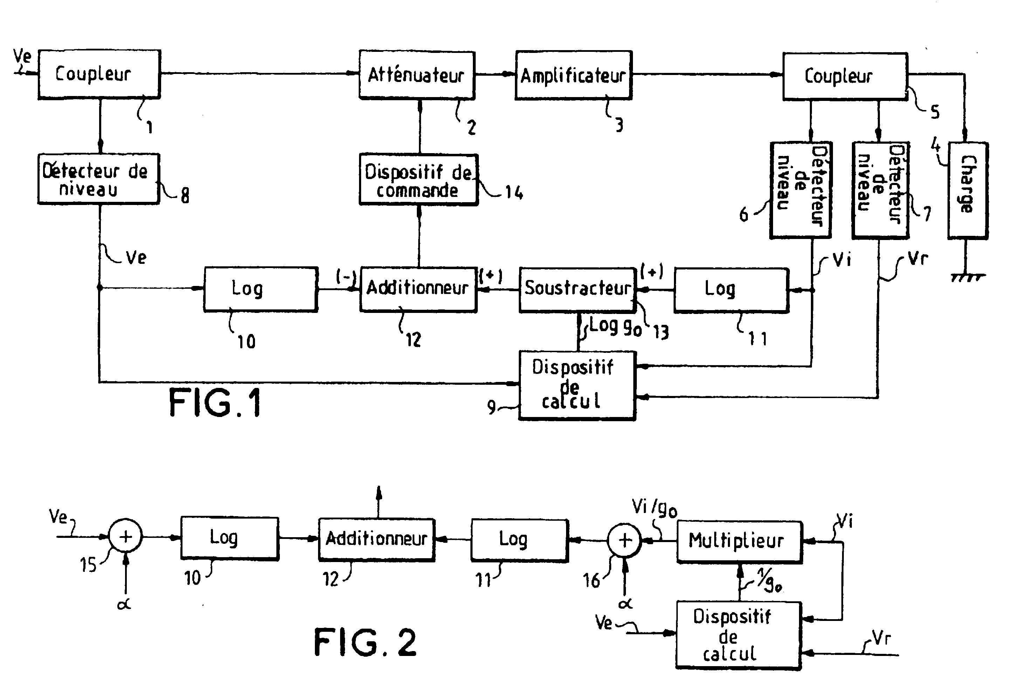

Dans l'exemple montré à la figure 1 le dispositif représenté 1 comprend reliés dans cet ordre en série, un coupleur 1 de prélèvement d'un signal d'entrée $v_e$, un atténuateur variable 2, et un amplificateur 3.

La sortie de l'amplificateur 3 est couplée à une charge 4 par l'intermédiaire d'un coupleur 5. Le coupleur 5 applique par une première sortie le signal incident délivré par l'amplificateur sur la charge 4, et fournit respectivement sur une deuxième et troisième sortie une copie du signal incident et du signal réfléchi par la charge 4, celles-ci étant redressées par des détecteurs de niveaux 6, 7 pour former respectivement des signaux redressés $V_i$ et $V_r$. De façon à peu près identique, une copie du signal d'entrée est fournie par le coupleur d'entrée 1 à un détecteur de niveau 8 pour former un signal redressé $V_e$. Un dispositif de calcul 9, formé par exemple par un microprocesseur convenablement programmé, détermine à partir des signaux redressés $V_e$, $V_i$ et $V_r$ une valeur du gain de consigne $g_o$. Les logarithmes des

valeurs des signaux redressés $V_e$ et $V_i$ sont calculés respectivement par deux circuits de calcul logarithmique 10 et 11. Les valeurs obtenues sont appliquées respectivement sur une première entrée d'opérande notée "-" d'un circuit additionneur 12 et sur une première entrée d'opérande notée "+" d'un circuit soustracteur 12. La valeur de gain de consigne $g_o$ calculée par le dispositif de calcul 9 est appliquée sur la deuxième entrée d'opérande du circuit soustracteur 13. La deuxième entrée d'opérande notée "+" du circuit additionneur 12 est reliée à la sortie du circuit soustracteur 13. Ainsi câblés les circuits 10, 11, 12 et 13 permettent d'obtenir à la sortie du circuit additionneur 12 un signal qui mesure le logarithme de l'écart $\varepsilon$ suivant la relation

$$\text{Log} \frac{V_i(t)}{g_o} - \text{Log} \, V_e = \text{Log} \varepsilon \qquad (2)$$

Selon un premier mode de réalisation de l'invention le logarithme de l'écart $\varepsilon$ est intégré sur une période de temps déterminée T par un circuit de commande 14 formé par un circuit intégrateur couplé entre la sortie du circuit additionneur 12 et l'entrée de commande d'un atténuateur variable 2 commandable en tension, de façon à pondérer la valeur de l'atténuateur en fonction du signal intégré fourni par l'intégrateur dans le sens qui permet de réduire l'écart $\varepsilon$.

Ce premier mode de réalisation de l'invention convient parfaitement pour calculer selon la relation (2) une valeur d'écart Log E lorsque les tensions $V_i$ et $V_e$ sont différentes de zéro. Cependant, pour des valeurs de $V_i$ et $V_e$ proches de zéro, les valeurs $\text{Log} \frac{V_i(t)}{g_o}$ et $\text{Log} \, V_o$ tendent théoriquement vers des valeurs très grandes qui rendent impossible la détermination de $\text{Log} \, \varepsilon$ à l'aide des simples circuits représentés.

Une solution à ce problème peut consister à substituer à la chaîne des éléments 9, 10, 11, 12 et 13 de la figure 1, la chaîne représentée à la figure 2 où les éléments sont homologues à ceux de la figure 1 sont représentés avec les mêmes références. Suivant ce deuxième mode de réalisation de l'invention le dispositif de calcul de l'écart $\text{Log} \, \varepsilon$ n'est plus réalisé suivant la relation (2) mais selon la relation

$$\text{Log} \left( \frac{V_i(t)}{g_o} + \alpha \right) - \text{Log} \left( V_e(t) + \alpha \right) = \text{Log} \, \varepsilon \qquad (3)$$

dans laquelle $\alpha$ représente une valeur de tension constante qui est négligeable devant les valeurs moyennes de $V_i(t)$ et $V_e(t)$. Cette solution permet d'obtenir une limite de $\text{Log} \, \varepsilon$ qui tend vers zéro lorsque $V_i(t)$ et $V_e(t)$ tendent vers zéro. Ceci est réalisé sur la figure 2 en introduisant deux circuits additionneurs 15 et 16 respectivement aux entrées des circuits logarithmiques 10 et 11 pour additionner d'une part, la tension $V_e(t)$ à la tension $\alpha$ et d'autre part, la tension $\frac{V_i(t)}{g_o}$ à la tension $\alpha$ en introduisant un circuit multiplieur 17 à la place du soustracteur 13 en sortie du dispositif de calcul 9 pour calculer le produit $\frac{V_i(t)}{g_o}$.

Selon un troisième mode de réalisation de l'invention le circuit de commande 14 et l'atténuateur 2 peuvent respectivement être réalisés de façon connue, à l'aide d'un compteur-décompteur évoluant au rythme d'un signal d'horloge et d'un diviseur à résistances non représentés, le diviseur à résistance étant commandé par le poids binaire du compteur-décompteur, le signal d'horloge étant appliqué sur le compteur-décompteur tant que le logarithme de l'écart $\varepsilon$ obtenu à la sortie du circuit additionneur 12 est extérieur à deux valeurs de seuil prédéterminées. Le coupleur 5 peut être réalisé de la manière représentée à la figure 2, par deux circuits couplés 18 et 19. Il comporte deux bornes d'entrées A et B et deux bornes de sorties C, D reliées respectivement à la sortie de l'amplificateur 3 et à la charge 4, les bornes B et D étant reliées au circuit de masse M du dispositif.

Le circuit couplé 18 est formé par deux enroulements dont l'un primaire qui comporte très peu de spires relativement à l'enroulement secondaire, a ses extrémités reliées respectivement aux bornes A et C.

Le circuit couplé 19 est formé par deux enroulements dont l'un primaire qui comporte beaucoup de spires relativement à l'enroulement secondaire, a ses extrémités reliées respectivement aux bornes A et B. L'enroulement secondaire du circuit couplé 19 possède un point milieu qui est relié à une première extrémité de l'enroulement secondaire du circuit couplé 18, la deuxième extrémité étant reliée à la masse M du dispositif par la borne D. Les extrémités de l'enroulement secondaire du circuit couplé 19 sont reliées respectivement au circuit de masse M du dispositif par la borne D par l'intermédiaire de résistances $R_1$ et $R_2$.

En désignant respectivement par $L_1$ et $L_2$ les inductances des enroulements secondaires et primaires des circuits couplés 18 et 19, le circuit 18 comprenant l'inductance $L_1$ prélève par son coefficient de mutuelle induction $M_1$ et les courants traversant les résistances $R_1$ et $R_2$, une information proportionnelle au courant $I = \frac{U_i - U_r}{Z_o}$ où $Z_o$ représente l'impédance de la charge 4 et $U_i$, $U_r$ les tensions incidentes et réfléchies entre les bornes A et B, respectivement C et D. Le circuit 18 comprenant l'inductance $L_2$ prélève par son coefficient de mutuelle induction $M_2$ et les courants traversant les résistances $R_1$, $R_2$ une information proportionnelle à la tension $U = U_i + U_r$.

Dans ce montage le courant $i_1$ traversant la résistance $R_1$ est proportionnel à $U_i$ et vaut $i_1 = \frac{1}{z_o} \frac{M}{L} U_i$ si la relation $\frac{M_1}{L_1} = \frac{M_2}{L_2} = \frac{M}{L}$ est vérifiée.

De même si la relation (3) est vérifiée le courant $i_2$ traversant la résistance $R_2$ est proportionnel à $U_r$ et vaut $i_2 = \frac{1}{z_o} \frac{M}{L} U_r$.

Les tensions $U_i$ et $U_r$ ainsi obtenues sont appliquées, après transformation en tension $V_i$ et $V_r$ par les détecteurs de niveaux 6 et 7, au dispositif de calcul 9 pour le calcul du taux d'onde stationnaire $\tau$ en appliquant la relation $\tau = \frac{U_i - U_r}{U_i + U_r}$.

Des tables de calcul de gain non représentées mémorisées à l'intérieur du dispositif de calcul 9 permettent d'attribuer à partir du taux d'onde stationnaire $\tau$ et de la tension $V_e$, une valeur du gain de consigne $g_o$.

Le même principe vaut également pour attribuer une valeur de gain de consigne en fonction d'autres paramètres que le taux d'onde stationnaire, comme par exemple la température ou la forme d'onde du signal amplifié, il suffit pour cela de mémoriser des tables correspondantes dans le dispositif de calcul 9.

## Revendications

1. Procédé de régulation du gain d'un amplificateur (3) de signaux haute fréquence caractérisé en ce qu'il consiste :

   - à déterminer (9) automatiquement une valeur de gain de consigne en fonction des conditions d'exploitation de l'amplificateur (3)
   - à mesurer (12) l'écart existant entre l'amplitude du signal appliqué à l'entrée de l'amplificateur (3) et celle d'un signal obtenu en divisant l'amplitude du signal fourni à la sortie de l'amplificateur (3) par la valeur de gain de consigne
   - et à minimiser l'écart existant, en pondérant l'amplitude du signal appliqué à l'entrée de l'amplificateur (14, 2) dans le sens qui permet de réduire l'écart.

2. Procédé selon la revendication 1 caractérisé en ce qu'il consiste à déterminer la valeur du gain de consigne en fonction du taux d'onde stationnaire existant à la sortie de l'amplificateur (3).

3. Procédé selon l'une quelconque des revendications 1 et 2 caractérisé en ce que la mesure de l'écart est déterminé par la relation la forme $\text{Log} \frac{V_i + \alpha}{g_o} - \text{Log } V_e + \alpha = \text{Log}\varepsilon$ où $V_i$ et $V_e$ correspondant respectivement aux tensions à la sortie et à l'entrée de l'amplificateur et $g_o$ correspond à une valeur de gain de consigne et $\alpha$ une tension constante négligeable devant les valeurs moyennes de $V_i$ et $V_e$.

4. Dispositif de régulation du gain d'un amplificateur (3) de signaux haute fréquence couplé à une charge (4) caractérisé en ce qu'il comprend d'une part, un dispositif de calcul (9) pour déterminer une valeur de gain de consigne en fonction des conditions d'exploitation de l'amplificateur (3) couplé à un dispositif de mesure (10, 11, 12, 13; 15, 16, 17) de l'écart existant entre l'amplitude du signal appliqué à l'entrée de l'amplificateur (3) avec celle d'un signal obtenu par division de l'amplitude du signal fourni à la sortie de l'amplificateur (3) par la valeur de gain de consigne et d'autre part, un atténuateur (2) commandé en fonction de l'écart mesuré par le dispositif de mesure (12), pour atténuer le signal d'entrée appliqué à l'entrée de l'amplificateur (3) dans le sens qui minimise l'écart mesuré.

5. Dispositif selon la revendication 4 caractérisé en ce qu'il comprend un coupleur (5) interposé entre la sortie de l'amplificateur (3) et la charge (4) pour appliquer à l'entrée du dispositif de calcul (8) une valeur correspondant à l'onde de tension directe fournie par l'amplificateur (3) à la charge (4) et une valeur correspondant à l'onde de tension réfléchie $V_r$ et en ce que le dispositif de calcul (9) est programmé pour calculer le taux d'onde stationnaire à la sortie de l'amplificateur et calculer le gain de consigne $g_o$ en fonction du taux d'onde stationnaire.

6. Dispositif selon l'une quelconque des revendications 4 et 5 caractérisé en ce que l'atténuateur est commandé en tension par la sortie du circuit de commande (14).

7. Dispositif selon la revendication 6 caractérisé en ce que le circuit de commande (13) est formé par un circuit intégrateur.

8. Dispositif selon l'une quelconque des revendications 4 et 5 caractérisé en ce que l'atténuateur est formé par un diviseur à résistance commandé par un circuit de commande (14) formé par un compteur-décompteur tant que l'écart mesuré est supérieur à une valeur de seuil prédéterminée.

EP 0 654 899 B1

**Patentansprüche**

1. Verfahren zur Regelung der Verstärkung eines Verstärkers (3) für Hochfrequenzsignale, das durch die folgenden Schritte gekennzeichnet ist:

   - es wird automatisch ein Sollverstärkungswert (9) in Abhängigkeit von den Betriebsbedingungen des Verstärkers (3) bestimmt,

   - es wird die Differenz zwischen der Amplitude des am Eingang des Verstärkers (3) anliegenden Signals und der Amplitude eines Signals (12) gemessen, das durch Division der Amplitude des am Ausgang des Verstärkers (3) gelieferten Signals durch den Sollverstärkungswert erhalten wird,

   - und es wird die bestehende Differenz minimiert, indem die Amplitude des am Eingang des Verstärkers (14, 2) anliegenden Signals in der Weise gewichtet wird,daß es ermöglicht wird, die Differenz zu vermindern.

2. Verfahren nach Anspruch 1, dadurch gekennzeichnet, daß der Sollverstärkungswert in Abhängigkeit vom Stehwellenverhältnis bestimmt wird, das am Ausgang des Verstärkers (3) vorliegt.

3. Verfahren nach Anspruch 1 oder Anspruch 2, dadurch gekennzeichnet, daß die Messung der Differenz anhand einer Gleichung der Form $Log \frac{V_i + \alpha}{g_0} - LogV_e + \alpha = Log\epsilon$ bestimmt wird, wobei $V_i$ und $V_e$ der Spannung am Ausgang bzw. am Eingang des Verstärkers, $g_o$ einem Sollverstärkungswert und $\alpha$ einer im Vergleich zu den Mittelwerten von $V_i$ und $V_e$ vernachlässigbaren konstanten Spannung entspricht.

4. Vorrichtung zur Regelung der Verstärkung eines Verstärkers (3) für Hochfrequenzsignale, der mit einer Last (4) verbunden ist, dadurch gekennzeichnet, daß er zum einen ein Rechenelement (9) zur Bestimmung eines Sollverstärkungswerts in Abhängigkeit von den Betriebsbedingungen des Verstärkers (3) umfaßt, das mit einer Vorrichtung (10, 11, 12, 13; 15, 16, 17) zur Messung der Differenz zwischen der Amplitude des am Eingang des Verstärkers (3) anliegenden Signals und der Amplitude eines Signals verbunden ist, das durch Division der Amplitude des am Ausgang des Verstärkers (3) gelieferten Signals durch den Sollverstärkungswert erhalten wird, und zum anderen einen Abschwächer (2) umfaßt, der in Abhängigkeit von der von der Meßvorrichtung (12) gemessenen Differenz gesteuert wird, um das am Eingang des Verstärkers (3) anliegende Eingangssignal in der Weise abzuschwächen, daß die gemessene Differenz minimiert wird.

5. Vorrichtung nach Anspruch 4, dadurch gekennzeichnet, daß sie einen Koppler (5) umfaßt, der zwischen den Ausgang des Verstärkers (3) und die Last (4) geschaltet ist, um an den Eingang des Rechenelements (8) einen der durch den Verstärker (3) zur Last (4) gelieferten direkten Spannungswellen entsprechenden Wert und einen der reflektierten Spannungswellen entsprechenden Wert anzulegen, und dadurch, daß das Rechenelement (9) so programmiert ist, daß es das Stehwellenverhältnis am Ausgang des Verstärkers und die Sollverstärkung $g_0$ in Abhängigkeit vom Stehwellenverhältnis berechnet.

6. Vorrichtung nach Anspruch 4 oder Anspruch 5, dadurch gekennzeichnet, daß der Abschwächer mittels einer Spannung über den Ausgang der Steuerschaltung (14) gesteuert wird.

7. Vorrichtung nach Anspruch 6, dadurch gekennzeichnet, daß die Steuerschaltung (13) durch eine Integrierschaltung gebildet wird.

8. Vorrichtung nach Anspruch 4 oder 5, dadurch gekennzeichnet, daß der Abschwächer durch einen Ohm'schen Spannungsteiler gebildet wird, der durch eine aus einem Vorwärts-Rückwärts-Zähler gebildete Steuerschaltung (14) solange gesteuert wird, wie die gemessene Differenz über einem vorherbestimmten Schwellenwert liegt.

**Claims**

1. Method for controlling the gain of a highfrequency signal amplifier (3), characterized in that it consists:

   - in automatically determining (9) a target gain value on the basis of the operating conditions of the amplifier (3)
   - in measuring (12) the difference existing between the amplitude of the signal applied at the input of the amplifier (3) and that of a signal obtained by dividing the amplitude of the signal delivered at the output of the amplifier

5

(3) by the target gain value
- and in minimizing the existing difference by weighting the amplitude of the signal applied at the input of the amplifier (14, 2) in such a way as to reduce the difference.

2. Method according to Claim 1, characterized in that it consists in determining the value of the target gain on the basis of the standing wave ratio existing at the output of the amplifier (3).

3. Method according to either one of Claims 1 and 2, characterized in that the measurement of the difference is determined by the equation of the form $\text{Log}\frac{V_i+\alpha}{g_0} - \text{Log } V_e + \alpha = \text{Log}\varepsilon$ where $V_i$ and $V_e$ correspond respectively to the voltages at the output and at the input of the amplifier and $g_0$ corresponds to a target gain value and $\alpha$ a constant voltage which is negligible compared with the average values of $V_i$ and $V_e$.

4. Device for controlling the gain of a high-frequency signal amplifier (3) coupled to a load (4), characterized in that it comprises, on the one hand, a calculating device (9) for determining a target gain value on the basis of the operating conditions of the amplifier (3), coupled to a device (10, 11, 12, 13; 15, 16, 17) for measuring the difference existing between the amplitude of the gain applied at the input of the amplifier (3) and that of a signal obtained by dividing the amplitude of the signal delivered at the output of the amplifier (3) by the target gain value, and on the other hand an attenuator (2) which is driven on the basis of the difference measured by the measuring device (12) in order to attenuate the input signal applied at the input of the amplifier (3) in such a way as to minimize the measured difference.

5. Device according to Claim 4, characterized in that it comprises a coupler (5) interposed between the output of the amplifier (3) and the load (4), in order to apply at the input of the calculating device (8) a value corresponding to the forward voltage wave delivered by the amplifier (3) to the load (4) and a value corresponding to the reflected voltage wave $V_r$, and in that the calculating device (9) is programmed to calculate the standing wave ratio at the output of the amplifier and calculate the target gain gO on the basis of the standing wave ratio.

6. Device according to either one of Claims 4 and 5, characterized in that the attenuator is voltage-driven by the output of the drive circuit (14).

7. Device according to Claim 6, characterized in that the drive circuit (13) is formed by an integrator circuit.

8. Device according to either one of Claims 4 and 5, characterized in that the attenuator is formed by a resistive divider driven by a drive circuit (14) formed by a reversible counter so long as the measured difference is greater than a predetermined threshold value.

**FIG.1**

Charge — 4
Coupleur — 5
Détecteur de niveau — 7 — Vr
Détecteur de niveau — 6 — Vi
Amplificateur — 3
Log — 11
Atténuateur — 2
Soustracteur (+) — Log $g_0$ — 13
Dispositif de commande — 14
Dispositif de calcul — 9
Additionneur (+) (-) — 12
Coupleur — 1
Log — 10
Détecteur de niveau — 8
Coupleur
Détecteur de niveau — Ve

**FIG.2**

Vi — Vr
Multiplieur — $^{Vi}/g_0$
Dispositif de calcul
Vi/$g_0$ — $\alpha$ — Ve — 16
Log — 11
Additionneur — 12
Log — 10
Ve — $\alpha$ — 15

FIG. 3